# EUROPEAN PATENT APPLICATION

(11) **EP 4 672 881 A1**
(43) Date of publication of application: **31.12.2025**
(21) Application number: 25184947.7
(22) Date of filing: 24.06.2025
(51) Int. Cl.: H05K 7/14, H02M 7/00, H02M 1/00

(54) **A BUS BAR ASSEMBLY OF A POWER CONVERTER**

(30) Priority: 27.06.2024 FR 2406932
(71) Applicant: Valeo eAutomotive Germany GmbH, 91056 Erlangen (DE)
(72) Inventor: MARIYAPPAN, Dineshkumar, 600130 Chennai, Tamil Nadu (IN); SIVAN, Danushkumar, 600130 Chennai, Tamil Nadu (IN)
(74) Representative: Valeo Powertrain Systems

(57) **Abstract**

The present subject matter relates to a bus bar assembly. More particularly, the present subject matter relates to a power converter 100 that includes an inverter, a boost converter, and a bus bar assembly 104. The inverter is provided with an inverter circuit adapted for converting a direct current (DC) to an alternate current (AC), the inverter being contained within a housing. The boost converter contained within the housing and provided with a boost converter circuit adapted to step up voltage from a low voltage level to a high voltage level. The bus bar assembly (104) includes three bus bars (106; 108; 110) passed through a single electromagnetic compatibility (EMC) filter (112). The three bus bars (106; 108; 110) include a positive bus bar (106), a negative bus bar (108), and a boost bus bar (110), all arranged within the housing and adapted to conduct positive DC power, negative DC power, and the output of the boost converter circuit, respectively.

## Description

### FIELD OF INVENTION

The present subject matter relates to a bus bar assembly of a power converter. The bus bar assembly described herein is preferably applicable for automotive applications.

### BACKGROUND

Electric vehicles (EVs) are becoming increasingly popular due to their environmental benefits and advancements in battery technology. In EVs, an inverter along with a boost converter is commonly used to control the electric motor's speed and torque, as well as to manage energy flow within the vehicles electrical system. The inverter converts direct current (DC) power into alternating current (AC) power to drive the motor thereby allowing for control of the motor's performance, including acceleration, decelaration, and regenerative braking. The boost converter steps up or boosts the voltage from the main traction battery to a higher level, usually to charge a 12 volt auxiliary battery or power other low voltage systems in the vehicle. The motor itself is powered by the inverter which converts DC from the main battery to AC power to drive the motor. In one scenario, boost converter is applicable for charging the main battery of an EV with an input side coupled to an external DC voltage charging source and the output side coupled to main battery. In one scenario, most of today's charging stations have a maximum voltage of 750 voltages while EVs in particular have a maximum voltage level of 870 volts. This means that the voltage of the charging station has to be stepped up (i.e., boost function) in order to be able to charge the EV with a high charging power.

To facilitate an interaction between the motor, inverter, and the boost converter, bus bars are used. Bus-bars are well known in electronic applications for facilitating flow of electric energy from one element to another element in an electric circuit. Typically, boost converters, or, step up converters (or, DCDC converters) include a boost bus bar for power transmission to facilitate the above described functions of the boost converter. Modern inverters are designed to include the boost converter incorporated therein. Such inverters include three main bus bars: a positive bus bar, a negative bus bar, and a boost bus bar. The positive and negative bus bars carry the main DC power from the battery to the inverter, while the boost bus bar carries the output of the boost converter, which steps up the volage as needed for various functions, for instance, to charge auxiliary systems.

However, current design of inverters with integrated boost converters may suffer from certain drawbacks. For example, the physical layout of the bus bars within the inverter enclosure can lead to inefficiencies in power transmission, increased heat generation, and challenges in assembly and maintenance.

Therefore, there is a need for an improved design of the bus bar configuration within the inverter with an integrated boost converter. Such a design should optimize power transmission efficiency, minimize heat generation, simplify assembly and maintenance peocesses, and enhance overall performance and reliability of the inverter system in applications not limited to EVs, but plug-in hybrid vehicles also.

Therefore, the technical problem to be solved by the present subject matter is how to provide a power converter ( such as, an inverter) wherein multiple bus bars within the housing are accomodated in a manner that the housing size is minimized. Further improvements to the power converter such as optimized power transmission efficiency, minimized heat generation, simplified assembly and maintenance peocesses, and enhanced overall performance and reliability of the power converter is sought.

### SUMMARY OF THE INVENTION

The present subject matter seeks to solve the above-mentioned technical problem in conventional power converters, and more particularly to power converters in which a boost converter circuit is incorporated.

The present subject matter relates to a power converter comprising: an inverter provided with an inverter circuit adapted for converting a direct current (DC) to an alternate current (AC), the inverter being contained within a housing; a boost converter contained within the housing and provided with a boost converter circuit adapted to step up voltage from a low voltage level to a high voltage level; and a bus bar assembly comprising three bus bars passed through a single Electromagnetic Compatibility filter, the three bus bars comprising: a positive bus bar, a negative bus bar, and a boost bus bar, arranged within said housing to conduct positive DC power, negative DC power, and the output of said boost converter circuit, respectively. Accordingly, the all three bus bars are accomodated in close proximity to one another and the overall size of the housing is reduced. Moreover, it is now possible for all three bus bars to be pass through a EMC filter. The internal components' layout within the power converter is more efficient.

The Electromagnetic Compatibility filter (or, EMC filter), in an aspect, is in the form of a container. The 'single' electromagnetic compatibility filter referred herein means that there is one container being referred to, and all the thee bus bars pass through the same container. The EMC filter attenuates electromagnetic interference noise, and ensures that the three bus bars do not radiate or conduct excessive interference which can disrupt the performance of other components. Further, EMC filter prevents errors and malfunctions that can occure due to electromagnetic intereference, resulting in a more reliable and stable power supply through the three bus bars.

According to an asepct of the present suject matter, the positive bus bar, the negative bus bar, and the boost bus bar is at least partially covered in an overmold part of electrically insulating material, the overmold part comprising multiple through holes into which fasteners are inserted. Accordingly, by virtue of all three bus bars being incorporated into a single part, i.e., the bus bar assembly, the assembly of the three bus bars is performed with fewer steps during production.

According to an aspect of the present subject matter, the positive bus bar, the negative bus bar, and the boost bus bar are spaced apart equally within the housing. Accordingly, irrespective of the proximity between the three bus bars, the assembly of the three bus bars and its production with the overmold part may be facilitated in a simpler manner.

According to another aspect of the present subject matter, the positive bus bar, the negative bus bar, and the boost bus bar are each comprised with multiple bends that are adapted to maneuver internal layout requirements within the housing. Accordingly, there an optimized placement of the bus bar assembly is facilitated within the housing.

According to an example of the present subject matter, the positive bus bar, the negative bus bar, and the boost bus bar are each divided into two sections in length, the two sections being: a first section comprising a first free end and a connected end at either ends along the first section's length, the connected end of the positive bus bar and negative bus bar being connected to the inverter circuit and the connected end of the boost bus bar adapted to connect to stator phases of a rotary machine; and a second section comprising at a second free end and a connector end at either ends along the second section's length, the connector end being adapted to connect to an electric power source. Accordingly, the three bus bars may be easily assembled. For instance, the EMC filter is applied to all three bus bars irrespective of the multiple bends formed on said bus bars.

According to an example of the present subject matter, the first free end and the second free end is joined together by brazing or welding. Accordingly, irrespective of all three bus bars being in close proximity, the two sections may be joined together with ease and without requiring fasteners and fastener torqueing tools.

According to an example of the present subject matter, one of the two sections comprise a straight portion that is devoid of bends, and is passed through the EMC filter. The straight portion allows for all the three bus bars to be passed through the EMC filter. The two sections may then be arranged for joining together. Ease of assembly is facilitated.

According to an aspect of the present subject matter, the overmold part further comprises a filter housing in which the Electromagnetic Compatibility (EMC) filter is accomodated. The EMC filter is provided with the filter housing in which the EMC is protected.

According to an example of the present subject matter, the filter housing comprises a snap fit opening through which a snap fit ridge, formed on the Electromagnetic Compatibility (EMC) filter, is inserted. Accordingly, the EMC filter is held in place in the filter housing. Rigidity of the bus bar assembly is ensured.

According to yet another example of the present subject matter, the overmold part further comprises enclosures in which capacitor modules is accomodated. Capacitor modules, such as Cx and Cy capacitors are accomodated within said enclosures, and are thereby structurally protected.

The present suject matter relates also to an electric system comprising: a rotary machine; an electric power source; and a power converter, configured in accordance with any of the preceding description.

The present subject matter has a particularly advantageous application in automotive applications where the rotary machine provides traction to an electric vehicle, or a hubrid electric vehicle.

### BRIEF DESCRIPTION OF DRAWINGS

The features, aspects, and advantages of the present invention will be better understood with regard to the following description and accompanying figures. The description refers to the annexed drawings, wherein:
FIG. 1 illustrates an exploded view of a power converter, configured in accordance with an aspect of the present subject matter;
FIG. 2A illustrates the power converter shown in FIG. 1, with the exception of a housing, and a bus bar assembly disassembled from a shield, the bus bar assembly being configured in accordance with an aspect of the present subject matter present subject matter;
FIG. 2B illustrates a perspective view of the bus bar assembly assembled to the shield, configured in accordance with the present subject matter;
FIG. 3A illustrates the bus bar assembly, configured in accordance with an aspect of the present subject matter;
FIG. 3B illustrates an exploded view of the bus bar assembly, configured in accordance with an aspect of the present subject matter;
FIG. 3C illustrates another perspective of the bus bar assembly shown in FIG. 3B;
FIG. 3D illustrates a top view of the bus bar assembly shown in FIG. 3C; and
FIG. 4 is a schematic illustration of an electric system, configured in accordance with an example of the present subject matter.

The figures are not necessarily to scale, and the size of some parts may be exaggerated to more clearly illustrate the example shown. Moreover, the drawings provide examples and/or examples consistent with the description, however, the description is not limited to the examples and/or examples provide in the drawings.

### DETAILED DESCRIPTION

In the description that follows, reference is made to accompanying drawings, which form part thereof, and in which is shown by way of illustration specific implementations in which the invention maybe practiced. These implementations are described in sufficient detail to enable that skilling in the art to practice the invention, and it is to be understood that the implementations may be combined, or that other implementations may be utilized, and that structural and logical changes may be made without departing from the scope of the present invention. The following detailed description is, therefore, not to be taken in a limiting sense, and the scope of the present invention is defined by the appended claims and their equivalents.

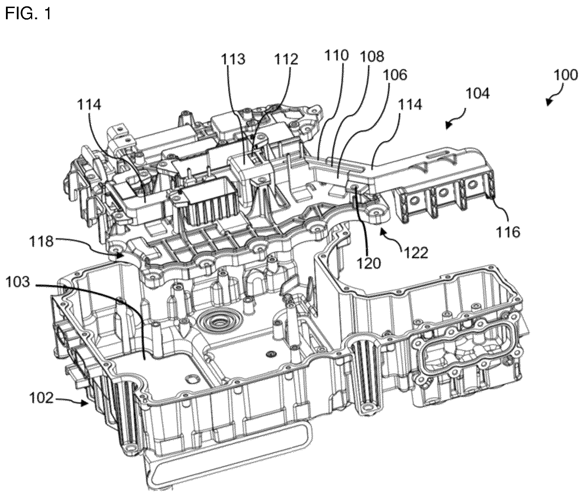

FIG. 1 illustrates an exploded view of a power converter 100, configured in accordance with an aspect of the present subject matter. The power converter 100 includes an inverter, a boost converter and a bus bas assembly 104. The inverter and the boost converter are contained within the housing 102. The inverter is provided with an inverter circuit that converts a direct current (DC) to alternate current (AC). The boost converter is provided with a boost converter circuit that steps up voltage from a low voltage level to a high voltage level. The bus bar assembly 104 includes three bus bars 106, 108. 110 passed through a single Electromagnetic Compatibility filter 112 (or, EMC filter 112). The three bus bars 106, 108, 110 include a positive bus bar 106, a negative bus bar 108, and a boost bus bar 110 arranged within the housing 102 to conduct positive DC power, negative DC power, and the output of the boost converter circuit, respectively.

According to an aspect of the present subject matter, the EMC filter 112 is in the form of a container. Further, all three bus bars 106, 108, 110 pass through a single EMC filter 112, meaning, there is one container and all three bus bars 106, 108, 110 is encapsulated within that one container. The single EMC filter 112, i.e., the container, ensures that the three bus bars 106, 108, 110 are properly aligned and secured.

This power converter 100 may be applied, for example, to an electric vehicle, and the inverter circuit may be configured to drive an electric motor (or "rotary machine") by the power from an in-vehicle battery. The vehicle may further be equipped with a low voltage battery to actuate auxiliary machines, such as a light and a radio. During operation, the three bus bars 106, 108, 110 of the power converter 100 each serve the purpose of dstributing power at different voltage levels. During a "driving mode" (i.e., the electric motor converts electric power from the inverter to provide a torque for driving the vehicle), the boost bus bar 110 is not directly involved in supplying the electric motor. In this mode, the inverter converts the DC voltage from the positive bus bar 106 and the negative bus bar 108 into AC voltage. This AC voltage is controlled to precisely match the electric motor's speed and torque requirement for efficient driving. In another mode, i..e, "charging mode", where the EV is plugged into an external charging station, DC voltage from the external charging station enters the inverter. The boost converter elevates this DC voltage to a level compatible with the in vehicle battery's voltage for efficient charging. The boost bus bar 110 therefore facilitates distribution of voltage that has been stepped up.

According to an example of the present subject matter, the positive bus bar 106, the negative bus bar 108 and the boost bus bar 110 are at least partially convered in an overmold part 114. The overmold part 114 is an electrically insulating material. The overmold part 114 is provided with multiple through holes 120 into which fasteners are passable. The bus bar assembly 104 is mounted on a shield 118. Further, the shield 118 is assembled within the housing's 102 chamber 103. On one side of the shield 118, the bus bar assembly 104 is mounted by means of the fasteners, and on the opposite side of the shield 118, or bottom side 122, a printed circuit board, or PCB, (not shown) is mounted. The inverter circuit is embedded to the PCB. The shield 118 functions as a bracket to protect components on one side of the shield 118 from EMC effects from the bottom side 122, and vice versa. Therefore, the bus bar assembly 114 is unaffected by any EMC effects generated by any components, for instance, power modules, DC link capacitors, etc., embedded to the PCB on the opposite side.

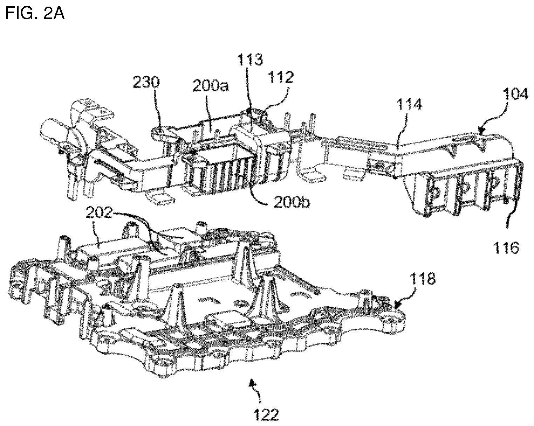

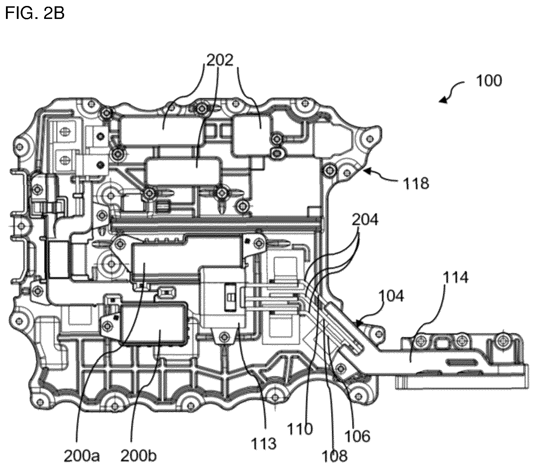

FIG. 2A illustrates a perspective where the shield 118 and the bus bar assembly 104 are disassembled from each other. FIG. 2B illustrates a top view of another perspective of the shield 118 and bus bar assembled 102 assembled together, configured in accordance with an aspect of the present subject matter. According to an aspect of the present subject matter, the overmold part 114 includes a filter housing 113 in which EMC filter 112 is accomodated. The overmold part 114 may further include enclosures 200a, 200b in which safety capacitors are contained, safety capacitors being provided to help minimize the generation of EMI (electromagnetic interference) / RFI (radio frequency interference) and negative effects associated with received EMI/RFI. For instance, the enclosure 200a contains Cx capacitor and enclosure 200b contains a Cy capacitor. Typical working of Cx capacitor and Cy capacitor are known, and therefore not described in detail for the sake of brevity in the present description.

According to an aspect of the present subject matter, the positive bus bar 106, the negative bus bar 108, and the boost bus bar 110 are spaced apart equally within the chamber 103. Further, the aforementioned three bus bars 106, 108, 110 are each formed to include multiple bends 204 based on layout requirements of all components disposed within the chamber 103 of the housing 102. Moreover, these multiple bends 204 facilitate electric power transfer in the circuitry (i.e., inverter circuit, boost converter circuit) irrespective of the topology configuration of the circuitry included in the power converter 100. For instance, the aforementioned circuitry includes relay switches (not shown in figures) arranged at the bottom side 122 of the shield 118. The shield 118 is provided with relay switch housing 202 that protrude from the side of the shield 118 where the bus bar assembly 104 is mounted. Therefore, by virtue of the multiple bends 204 of the three bus bars 106, 108, 110, the bus bas assembly 104 is configured to maneuver the internal layout requirements within the housing (102).

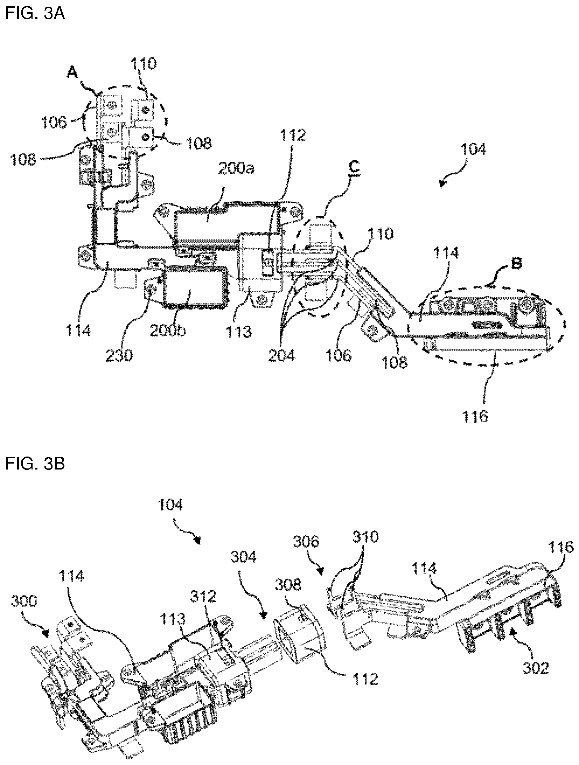

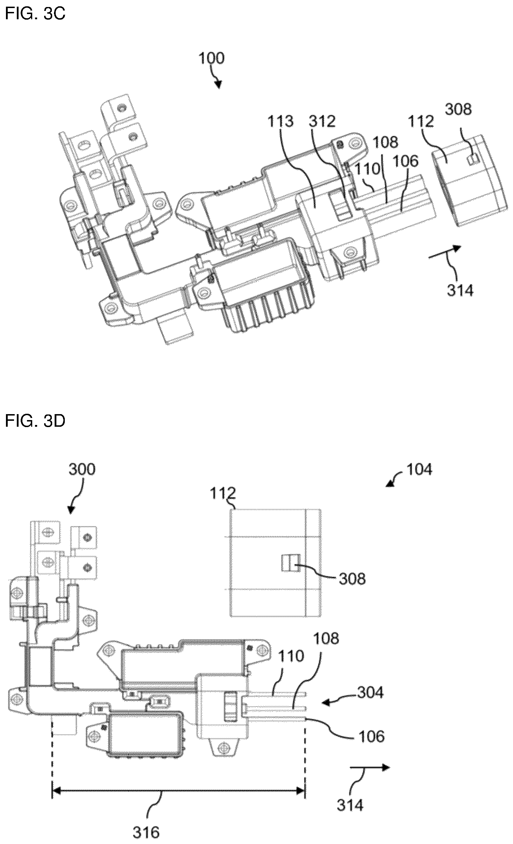

FIG. 3A illustrates the bus bar assembly, configured in accordance with an aspect of the present subject matter. FIG. 3B illustrates an exploded view of the bus bar assembly 104. FIG. 3C illustrates a perspective view of the bus bar assembly 104 with few components removed from view, and configured in accordance with the present subject matter. FIG. 3D illustrates a top view of the bus bar assembly 104 shown in FIG. 3C.

As described in a preceding paragraph, the bus bar assembly 104 and particulalry the three bus bars 106, 108, 110 distribute power at different voltage levels. The three bus bars 106, 108, 110 extend between two extremities where the three bus bars 106, 108, 110 provide or receive electric power for distribution. The two extremities may be referred at region A and region B, as shown in FIG. 3A. The region A depicts a connected end 300 of the bus bar assembly 104, more particularly, the connected end of the three bus bars 106, 108, 110. Each of the three bus bars 106, 108, 110 are crimped at the region A to faciliate a connection with another electronic component or circuit. The connected end 300 of the positive bus bar 106 is connected to the inverter circuit. The connected end 300 of the negative bus bar 108 has two crimped locations, one being connected to the inverter circuit and the second of the two crimpled locations being connected to stator phases of the rotary machine. The connected end 300 of the boost bus bar 110 is connected to stator phases of a rotary machine also. The region B depicts a connector end 302 of the bus bar assembly 104 where the three bus bars 106, 108, 110, namely, the positive bus bar 106, the negative bus bar 108, and the boost bus bar 110 are covered in the overmold part 114. The overmold part 114 in the region B is formed as a connector 116 which, in an electric vehicle application, is suitable for connecting to an electric power source, such as an in vehicle battery.

According to an example of the present subject matter, the positive bus bar 106, the negative bus bar 108, and the boost bus bar 110 are each divided into two sections in length between the two regions A and B. Region C, shown in FIG. 3B depicts a portion of the bus bar assembly 104 where the two sections are joined together. The two sections include a first section and a second section. The first section extends in length between the connected end 300 in section A and a free end 304 in section C. The second section extends in length between the connector end 302 in section B and the second free end 306 in section B. The first free end 304 and the second free end 306 are joined together, for instanace, by brazing or welding.

According to an example of the present subject mattter, each of the three bus bars 106, 108, 110, at the second free end 306, include projections 310 that are soldered to the PCB. These projections 310 connect to the Cy capacitor contained in the enclosure 200b and provide grounding via fasteners inserted through the holes 230 formed in proximity to the enclosure 200b.

According to another example of the present subject matter, the first portion of the three bus bars 106, 108, 110 includes a straight portion 316 that is devoid of bends. The straight portion 316 is closed at least in part my the overmold part 114. The straight portion 316 extends in a direction parallel to 314 shown in FIG. 3C and FIG. 3D. Further, the EMC filter 112 is formed to include passages extending parallel to the direction 314 and therefore permit the positive bus bar 106, the negative bus bar 108, and the boost bus bar 110 to pass through. The filter housing 113 is open in the direction 314 from the side facing the first free end 304 to permit the EMC filter 112 to enter. The EMC filter is provided with a snap fit ridge 308 that is locked within a snap fit opening 312 formed on the filter housing 113.

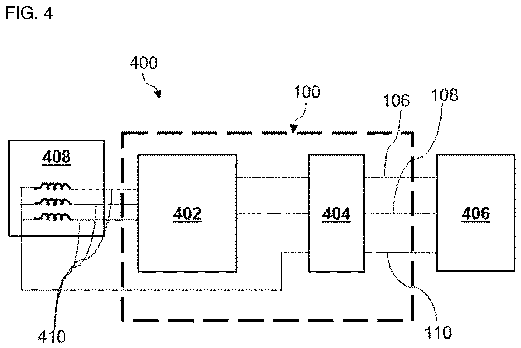

FIG. 4 is a schematic illustration of an electric system 400 that includes a rotary machine 408, an electric power source 406, and the power converter 100 configured in accordance with the present subject matter. In the charging mode, there is a flow of electric power from an external power source (for instance, an external charging station) to the rotary machine 408 via the boost bus bar 110. From the rotary machine 408, there is a flow of electric power to the inverter circuit 402 via phase connectors (410) of the rotary machine 408. From the inverter circuit 402, the positive bus bar 106 and the negative bus bar 108 facilitates a flow of electric power to the electric power source 406, for instance a battery..

According to an example, the external power source (not shown) is electrically connected to the electric system 400 by way of a charging cable (not shown).

In an example, the electric system 400 may be applied to an electric vehicle. The inverter circuit 402 drives the rotary machine 408 by the power from the electric power source 406. The rotary machine 408 is a polyphase machine, and preferably, a three phase rotary machine 408. Accordingly, the inverter 402 is configured to power the three phase rotary machine 408. The electric vehicle may further be equipped with a low voltage battery to actuate auxiliary machines, such as a light and a radio. During operation, the three bus bars 106, 108, 110 of the power converter 100 each serve the purpose of distributing power at different voltage levels. During a "driving mode", the boost bus bar 110 is not directly involved in supplying the rotary machine 408. In this mode (i.e., in the driving mode), the inverter circuit 402 converts the DC voltage from the positive bus bar 106 and the negative bus bar 108 into AC voltage. This AC voltage is controlled to precisely match the rotary machine's 408 speed and torque requirement for efficient driving. The boost bus bar 110 remains inactive or operates to regulate power for high voltage accessories (if applicable) but does not provide power to the rotary machine 408. In the charging mode, where the EV is plugged into an external charging station (not shown), DC voltage from the external charging station enters the inverter circuit 402. The boost converter circuit 404 elevates this DC voltage to a level compatible with electric power source's 406 voltage for efficient charging. The boost bus bar 110 therefore facilitates distribution of voltage that has been stepped up. The three bus bars 106, 108, 110 are passed through a single EMC filter 112 which is snap fitted to the filter housing 113 formed on the overmold part 114.

Various modifications of the disclosed embodiments, as well as alternate embodiments of the subject matter, will become apparent to persons skilled in the art upon reference to the description of the subject matter. It is therefore contemplated that such modifications can be made without departing from the scope of the present subject matter is defined.

## Claims

1. Power converter (100) comprising:
an inverter provided with an inverter circuit (402) adapted for converting a direct current (DC) to an alternate current (AC), the inverter being contained within a housing (102);
a boost converter contained within the housing (102) and provided with a boost converter circuit (404) adapted to step up voltage from a low voltage level to a high voltage level; and
a bus bar assembly (104) comprising three bus bars (106; 108; 110) passed through a single Electromagnetic Compatibility (EMC) filter (113), the three bus bars (106; 108; 110) comprising:
a positive bus bar (106), a negative bus bar (108), and a boost bus bar (110), arranged within said housing (102) to conduct positive DC power, negative DC power, and the output of said boost converter circuit (404), respectively.

2. Power converter (100) as claimed in claim 1, wherein the positive bus bar (106), the negative bus bar (108), and the boost bus bar (110) is at least partially covered in an overmold part (114) of electrically insulating material, the overmold part (114) comprising multiple through holes (202) into which fasteners are inserted.

3. Power converter (100) as claimed in the preceding claim, wherein the positive bus bar (106), the negative bus bar (108), and the boost bus bar (110) are spaced apart equally within the housing (102).

4. Power converter (100) as claimed in any one of the preceding claim, wherein the positive bus bar (106), the negative bus bar (108), and the boost bus bar (110) are each comprised with multiple bends (204) that are adapted to maneuver internal layout requirements within the housing (102).

5. Power converter (100) as claimed in the preceding claim, wherein the positive bus bar (106), the negative bus bar (108), and the boost bus bar (110) are each divided into two sections in length, the two sections being:
a first section comprising a first free end (304) and a connected end (300) at either ends along the first section's length, the connected end (300) of the positive bus bar (106) and negative bus bar (108) being connected to the inverter circuit (402) and the connected end (300) of the boost bus bar (110) adapted to connect to stator phases of a rotary machine; and
a second section comprising a second free end (306) and a connector end (302) at either ends along the second section's length, the connector end (302) being adapted to connect to an electric power source (406).

6. Power converter (100) as claimed in the preceding claim, wherein the first free end (304) and the second free end (306) is joined together by brazing or welding.

7. Power converter (100) as claimed in the preceding claim, wherein one of the two sections comprise a straight portion (316) that is devoid of bends, and is passed through the EMC filter (112).

8. Power converter (100) as claimed in the preceding claim, wherein the overmold part (114) further comprises a filter housing (113) in which the Electromagnetic Compatibility (EMC) filter (112) is accomodated.

9. Power converter (100) as claimed in the preceding claim, wherein the filter housing (113) comprises a snap fit opening (312) through which a snap fit ridge (308), formed on the Electromagnetic Compatibility (EMC) filter (112), is inserted.

10. Power converter (100) as claimed in the preceding claim, wherein the overmold part (114) further comprises enclosures (200a; 200b) in which capacitor modules is accomodated.

11. Electric system (400) comprising:
a rotary machine (408);
an electric power source (406); and
a power converter (100), configured in accordance with any one of the preceding claims.
